# EUROPEAN PATENT APPLICATION

(11) **EP 3 979 223 A1**
(43) Date of publication of application: **06.04.2022**
(21) Application number: 20199576.8
(22) Date of filing: 01.10.2020
(51) Int. Cl.: G08G 1/042, B60T 7/22, B60T 8/171, B60W 30/14, G01R 33/00

(54) **A COIL ARRANGEMENT, A VEHICLE, A DECELERATION SYSTEM, AND A METHOD**

(71) Applicant: Vestel Elektronik Sanayi ve Ticaret A.S., 45030 Manisa (TR)
(72) Inventor: ULUAG, Onur, 45030 Manisa (TR)
(74) Representative: Kehl, Ascherl, Liebhoff & Ettmayr Patentanwälte Partnerschaft mbB

(57) **Abstract**

The present invention provides a coil arrangement (100, 200) for a vehicle (320, 440, 441, 442, 540, 541, 542), the coil arrangement (100, 200) comprising a number of coils (101, 102, 201, 202, 330, 331, 332, 333), each coil (101, 102, 201, 202, 330, 331, 332, 333) being couplable to the vehicle (320, 440, 441, 442, 540, 541, 542) and being configured to controllably generate a magnetic field (103, 104, 203, 204, 334, 335, 336, 337, 445, 446, 447, 448, 449, 450, 545, 546, 547, 548, 549, 550), wherein the longitudinal axis of the coils (101, 102, 201, 202, 330, 331, 332, 333) is parallel to the longitudinal axis of the vehicle (320, 440, 441, 442, 540, 541, 542), an energy storage (105, 205) electrically coupled to the coils (101, 102, 201, 202, 330, 331, 332, 333) and configured to store electrical energy and supply the coils (101, 102, 201, 202, 330, 331, 332, 333) with electrical energy, and a controller (106, 206) electrically coupled between the energy storage (105, 205) and the coils (101, 102, 201, 202, 330, 331, 332, 333) and configured to control the energy flow of electrical energy from the energy storage (105, 205) to the coils (101, 102, 201, 202, 330, 331, 332, 333) based on a required strength and/or duration for the magnetic fields (103, 104, 203, 204, 334, 335, 336, 337, 445, 446, 447, 448, 449, 450, 545, 546, 547, 548, 549, 550). Further, the present invention refers to a vehicle (320, 440, 441, 442, 540, 541, 542), a deceleration system 439, 539 and a method.

## Description

### TECHNICAL FIELD

The invention relates to a coil arrangement for a vehicle. Further, the present invention refers to a vehicle, a deceleration system and a method.

### BACKGROUND

Although applicable to any vehicle, the present invention will mainly be described in conjunction with road vehicles.

Vehicles, like e.g. passenger cars, need to provide the driver with the ability to decelerate the vehicle when needed. To this end, such vehicles usually comprise a hydraulic braking system that is based on braking discs arranged on the wheel and braking pads arranged with a caliper on the vehicle chassis. By actuating a braking pedal, the driver of the vehicle may decelerate the vehicle as needed.

Especially in risky situations the driver may want to quickly stop the vehicle with the shortest stopping distance possible.

The stopping distance of a vehicle usually builds up of the distance travelled by the vehicle until the driver reacts, i.e. pushes the brake pedal, called reaction distance, and the actual distance required to stop the vehicle after active deceleration of the vehicle is initiated, called braking distance.

The reaction time depends on the individual driver and may be reduced e.g. by respective driver assistance systems, like e.g. an automated braking systems. Such systems usually comprise very complex and expensive electronical and mechanical devices.

The braking distance relies on the friction force between the tires of the vehicle and the road, the friction force between the brake pads and the brake discs and to some extend on aerodynamic drag. The total friction force is affected by multiple factors, like e.g. the tires, the vehicle's velocity and the vehicle's weight.

In an exemplary situation two vehicles may be moving in the same direction one after the other. If the vehicle in the front starts braking, the second vehicle will only initiate active braking after the driver of the second vehicle sees the first vehicle braking and then pushes the brake pedal, because of the reaction time of the human driver. The longer the driver of the second vehicle needs to identify the braking of the first vehicle the longer the braking distance will be for the second vehicle.

Accordingly, there is a need for shortening the braking distance of vehicles.

### SUMMARY OF THE INVENTION

The above stated problem is solved by the features of the independent claims. It is understood, that independent claims of a claim category may be formed in analogy to the dependent claims of another claim category.

Accordingly, it is provided:
A coil arrangement for a vehicle, the coil arrangement comprising a number of coils, each coil being couplable to the vehicle and being configured to controllably generate a magnetic field, wherein the longitudinal axis of the coils is parallel to the longitudinal axis of the vehicle, an energy storage electrically coupled to the coils and configured to store electrical energy and supply the coils with electrical energy, and a controller electrically coupled between the energy storage and the coils and configured to control the energy flow of electrical energy from the energy storage to the coils based on a required strength and/or duration for the magnetic fields.

Further, it is provided:
A vehicle comprising a coil arrangement according to the present invention, wherein the coils of the coil arrangement are arranged wound around beams of the chassis of the vehicle.

Further, it is provided:
A deceleration system for vehicles, the deceleration system comprising a first coil arrangement according to the present invention and coupled to a first vehicle, a second coil arrangement according to the present invention and coupled to a second vehicle, wherein the first coil arrangement is configured to generate a first magnetic field of a predetermined polarity between the first vehicle and the second vehicle, and wherein the second coil arrangement is configured to generate a second magnetic field with the predetermined polarity between the first vehicle and the second vehicle.

Further, it is provided:
A method for decelerating a vehicle with a coil arrangement according the present invention, the method comprising storing electrical energy for controllably supplying coils of the coil arrangement with electrical energy, and controlling the energy flow of electrical energy to the coils based on a required strength and/or duration for the magnetic fields.

The present invention is based on the finding that using only the friction force between the tires of the vehicle and the road and to some extend aerodynamic drag limits the ability to decelerate a vehicle.

The present invention makes use of this finding by providing an additional force that may be applied to decelerate a vehicle. This additional force used by the present invention is a magnetic force that is applied not between the vehicle and the road but between two vehicles that drive one behind the other.

To this end, the present invention provides the coil arrangement that may be provided on vehicles and a respective deceleration system. The coil arrangement and the deceleration system may be operated according to the method provided by the respective invention.

The coil arrangement comprises a number of coils. The coils serve to generate the magnetic fields between the vehicles required to decelerate vehicles driving behind other vehicles. The single coils may therefore be coupled to the respective vehicle. The longitudinal axes of the coils may be aligned with the longitudinal axis of the vehicle, i.e. the axis from the front of the vehicle to the back of the vehicle. Aligned in this regard refers to the longitudinal axes of the coils being arranged in parallel or within a predetermined angle to the longitudinal axes of the vehicle, especially in a plane parallel to ground. This angle may be relatively small, e.g. less than 10° or less than 5° or less than 4°, 3°, 2° or 1°. Another possibility to define the orientation of the coils is to define the coils by the main axis of the magnetic field or the main direction of the lines of the resulting magnetic flux. The orientation of the coils may be defined such that the main axis of the resulting magnetic field is parallel or almost parallel, e.g. within a predetermined angle of less than 10°, 5°, 4°, 3°, 2° or 1° to the longitudinal axes of the vehicle, especially in a plane parallel to ground. It is understood, that in this context, the longitudinal axis of the coil refers to the main axis of the magnetic field or the main direction of the lines of the resulting magnetic flux. Therefore, the main axis may also be defined for planar coils, also called pancake coils, or bifilar coils, as the main axis of the magnetic field, e.g. the axis of straight flux lines.

The coil arrangement further comprises an energy storage that is electrically coupled to the single coils. The energy storage stores electrical energy and supplies the coils with electrical energy. It is understood, that the energy storage may be recharged via a plurality of different solutions. The energy storage may e.g. be coupled to the vehicle's electric supply network and may be recharged with the electrical power provided in that supply network. It is understood, that such a supply network may e.g. comprise an electrical generator e.g. coupled to a combustion engine, or any other type of electrical generator. The energy storage may e.g. comprise capacitors, so called super-capacitors, batteries or the like to store the electrical energy.

The supply of electrical energy to the coils is controlled by a controller that is electrically coupled between the energy storage and the coils. The controller controls the energy flow of electrical energy from the energy storage to the coils based on a required strength and/or duration for the magnetic fields.

The required strength and/or duration for the magnetic fields indicates to the controller how strong the additional braking force generated by the coil arrangement should be, and therefore provides an indication about the strength of the magnetic fields generated by the coils and the duration for which the additional braking force is required.

The required strength and/or duration for the magnetic fields may comprise values that are externally provided to the controller, e.g. via other electronic systems or electronic control units, ECUs, in the vehicle. To this end, the controller may e.g. comprise a communication interface, like e.g. a CAN-bus interface, a Flex Ray interface, a network interface or the like.

As alternative, the controller may calculate the required strength and/or duration for the magnetic fields based on data provided to the controller from other vehicle systems or based on data measured by the controller with respective sensors, e.g. a deceleration of the vehicle, or a distance to another vehicle traveling in front of the vehicle.

Coil arrangements may be provided on different vehicles and form a deceleration system for vehicles. If a second vehicle is trailing a first vehicle and both vehicles are equipped with a coil arrangement, a magnetic force may be generated between both vehicles to provide an additional braking force to the trailing vehicle in case that the trailing vehicle's driver actively decelerates the vehicle.

To this end, a magnetic field is generated between the leading or first vehicle and the trailing or second vehicle by the coils in the leading vehicle and a respective magnetic field is generated by the coils in the trailing vehicle. It is understood, that in order to decelerate the trailing vehicle in respect to the leading vehicle, the magnetic fields generated by the coils in both vehicles have the same polarity, e.g. north or south polarity. With this configuration the generated magnetic fields will repel each other and therefore decelerate the trailing vehicle with respect to the leading vehicle.

Further embodiments of the present invention are subject of the further subclaims and of the following description, referring to the drawings.

In an embodiment, the controller may be configured to sense via the coils a first polarity of a magnetic field generated by an external coil arrangement in front of the vehicle and to control the coils to generate a magnetic field in front of the vehicle with a polarity equal to the first polarity. In addition, or as alternative, the controller may be configured to sense via the coils a second polarity of a magnetic field generated by an external coil arrangement behind the vehicle and to control the coils to generate a magnetic field behind the vehicle with a polarity equal to the second polarity.

The controller may use the coils that generate the magnetic field in a trailing vehicle as sensors to sense the polarity of the magnetic field generated by coils in a leading vehicle. The same applies to the situation, where a magnetic field is generated behind a vehicle. This may e.g. be the case, if the driver of a trailing vehicle does not pay attention and rapidly approaches the leading vehicle. As soon as the leading vehicle catches the attention of the driver of the trailing vehicle, this drive will start braking the trailing vehicle. The controller of the coil arrangement of the leading vehicle may sense the polarity of the magnetic field generated by the coils in the trailing vehicle and start generating a respective magnetic field with the same polarity between the trailing and the leading vehicle.

Therefore, the controller of a coil arrangement may always control the coils to generate a magnetic field with the correct polarity required to decelerate the trailing vehicle.

In a further embodiment, the coil arrangement may comprise a communication interface, especially a wireless communication interface, coupled to the controller. The controller may be configured in an embodiment to receive via the communication interface an indication of a first polarity of a magnetic field generated by an external coil arrangement in front of the vehicle and to control the coils to generate a magnetic field in front of the vehicle with a polarity equal to the first polarity. In addition, or as alternative, the controller may be configured to receive via the communication interface an indication of a second polarity of a magnetic field generated by an external coil arrangement behind the vehicle and to control the coils to generate a magnetic field behind the vehicle with a polarity equal to the second polarity.

In addition, or as alternative to using the coils of the coil arrangement to sense the polarities of externally generated magnetic fields, the controller may be coupled to a communication interface. Different coil arrangements may therefore communicate via the coil arrangement the polarities of the respectively generated magnetic fields.

It is understood, that in addition to a communication interface, the coil arrangement may also comprise or be coupled to a position determination sensor, like e.g. a GPS sensor. This allows the controllers of two different coil arrangements to determine their relative position with regard to each other. The controllers may with this information determine, which vehicle is the trailing vehicle and which vehicle is the leading vehicle. Therefore, each controller may control the correct coils, e.g. at the front of the vehicle or at the back of the vehicle to generate a respective magnetic field with the correct polarity.

In another embodiment, at least one of the coils may be arranged at the front of the vehicle, especially at each one of two sides of the vehicle at the front of the vehicle one coil may be arranged. In addition, or as alternative, at least one of the coils may be arranged at the back of the vehicle, especially at each side of two sides of the vehicle at the back of the vehicle one coil may be arranged.

A vehicle has a longitudinal axis, from the front of the vehicle to the back of the vehicle. This axis is also called the x axis, wherein the driver usually faces to the front of the vehicle. Usually, a vehicle will comprise a chassis with a respective frame.

Such a frame usually comprises a plurality of beams that form the basis for mounting other parts of the vehicle, like e.g. the traction system, the body, and the like.

A coil of the coil system may be mounted on the front of the vehicle and another coil on the back of the vehicle. However, the coils of the coil arrangement may also be mounted in pairs on the vehicle, two coils in the front and two coils in the back. It is understood, that while separate coil mountings may be provided with the coil system to mechanically arrange the coils in the vehicle, the coils may also be wound around respective beams of the frame of the vehicle.

For example, a frame of a vehicle may comprise a beam to the left of the engine compartment and a beam to the right of the engine compartment. A coil may therefore be wound around each of these beams to provide to coils at the front of the vehicle, one on the left and one of the right.

The same applies to the back of the vehicle. The frame of the vehicle may comprise two beams in the back, one beam on the left of the trunk and one beam on the right of the trunk. A coil may therefore be wound around each one of these beams to provide two coils at the end of the vehicle.

It is understood, that the frame of the vehicle may as a base for the coils form a common magnetic core for a plurality of the coils. The coils may therefore form a mutually induced coil array on the frame. To this end, the frame of the vehicle may in an embodiment comprise a high permeability material to optimize the magnetic flux and therefore the mutual inductance.

Where required, a magnetic insulator material may be provided on the frame or in the vehicle chassis, where required, to prevent the formation of a closed loop of the magnetic circuit and to set the correct directionality of the mutual inductance.

In a further embodiment, the controller may be configured to control the at least one coil at the front of the vehicle to generate a magnetic field with a predefined polarity and to control the at least one coil at the back of the vehicle to generate a magnetic field with a polarity that is opposed to the predefined polarity.

In this arrangement, the controller will control the coils such that magnetic fields with different polarizations are generated at the front and the back of the vehicle. This configuration may be advantageous if the frame of the vehicle is configured to form a common magnetic core for all coils of the coil arrangement.

As alternative, the controller may be configured to control the at least one coil at the front of the vehicle to generate a magnetic field with a predefined polarity and to control the at least one coil at the back of the vehicle to generate a magnetic field with the same polarity.

In this arrangement, the controller will control the coils such that magnetic fields with the same polarizations are generated at the front and the back of the vehicle. This configuration may be used to flexibly adapt the generated magnetic fields to already present magnetic fields around the respective vehicle.

In another embodiment, the controller may be configured to determine based on the speed of the vehicle and/or the distance between the vehicle and another vehicle and/or the momentary deceleration of the vehicle a field strength and a duration for the magnetic fields generated by the coils.

It is understood, that the speed of the vehicle and/or the distance between the vehicle and another vehicle and/or the momentary deceleration of the vehicle may be used to determine the required strength and/or duration for the magnetic fields.

For example, the required field strength may be proportional to the speed of the vehicle, since with higher speed higher braking forces may be required. In contrast, the duration for generating the fields may be inverse proportional to the distance between the vehicle and a leading vehicle, since if the vehicle is very near behind the leading vehicle, the magnetic fields may permanently provide an additional braking force during deceleration of the vehicle. Further, the strength of the magnetic fields, may also proportional to the deceleration of the vehicle, since it may be assumed that a driver want's to quickly stop the vehicle if he strongly uses the conventional brakes of the vehicle.

In an embodiment, the controller may be configured to use the coils of the coil arrangement to detect objects in front of the vehicle or behind the vehicle by their influence on the inductivity of the single coils. With this arrangement, the coil arrangement may be used as an inductive distance measurement system and therefore as a collision detection system in the vehicle. The distance to conventional vehicles without a coil arrangement may be measured by the influence of the magnetic materials of such vehicles on the coil arrangement. The distance to vehicles that comprise the coil arrangement may be measured based on the magnetic fields that such coil arrangements generate. It is understood, that the controller may output information about an imminent collision via a vehicle communication network, like e.g. a CAN-Bus, a FlexRay-Bus or the like.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
Fig. 1 shows a block diagram of an embodiment of a coil arrangement according to the present invention;
Fig. 2 shows a block diagram of another embodiment of a coil arrangement according to the present invention;
Fig. 3 shows a top view of an embodiment of a vehicle according to the present invention;
Fig. 4 shows a schematic diagram of an embodiment of a deceleration system according to the present invention with multiple vehicles;
Fig. 5 shows a schematic diagram of another embodiment of a deceleration system according to the present invention with multiple vehicles; and
Fig. 6 shows a flow diagram of an embodiment of a method according to the present invention.

In the figures like reference signs denote like elements unless stated otherwise.

### DETAILED DESCRIPTION OF THE DRAWINGS

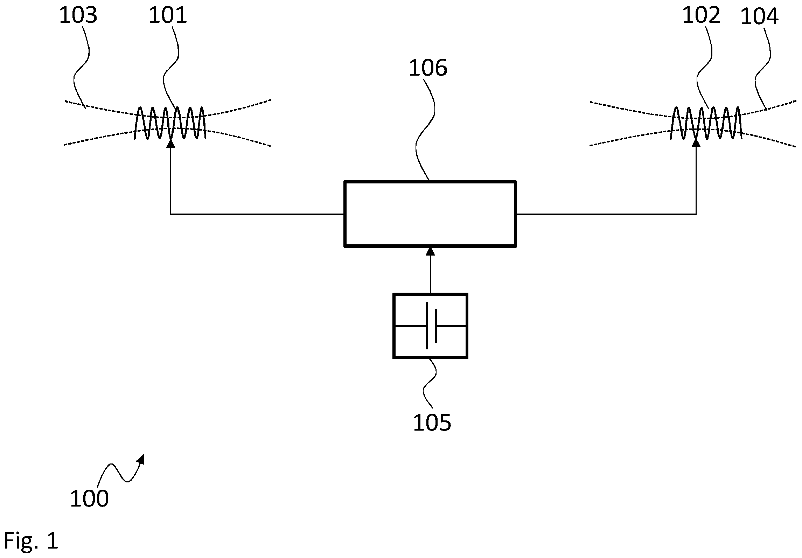

Fig. 1 shows a block diagram of a coil arrangement 100. The coil arrangement 100 may e.g. be used in a vehicle to provide an additional braking force. The coil arrangement 100 comprises two exemplary coils 101, 102 that are coupled via controller 106 to an energy storage 105.

It is understood, that the number of two coils is just exemplarily chosen and that any other number of coils may be provided. Each coil 101, 102 may be coupled to the vehicle and may controllably generate a magnetic field 103, 104. The longitudinal axis of the coils 101, 102 is in an embodiment parallel to the longitudinal axis of the vehicle, to provide a braking force in the direction of movement of the vehicle.

The energy storage 105 is electrically coupled to the coils 101, 102 via controller 106 and stores electrical energy that may be supplied the coils 101, 102. The controller 106 controls the energy flow of electrical energy from the energy storage 105 to the coils 101, 102 based on a required strength and duration for the magnetic fields 103, 104.

To provide the coils 101, 102 with the correct driving signals such that the magnetic fields 103, 104 are generated with the correct polarity, the controller 106 may sense via the coils 101, 102 a first polarity of a magnetic field 103, 104 generated by an external coil arrangement in front of the vehicle and may control each of the coils 101, 102 to generate a magnetic field 103, 104 in front of the vehicle with a polarity equal to the first polarity. The controller 106 may also sense via the coils 101, 102 a second polarity of a magnetic field 103, 104 generated by an external coil arrangement behind the vehicle and may control the coils 101, 102 to generate a magnetic field 103, 104 behind the vehicle with a polarity equal to the second polarity.

It is understood, that instead of sensing the polarities of external magnetic fields, the controller 106 may also control the coils 101, 102 to generate magnetic fields with a predefined polarity.

The controller 106 may control coils 101, 102 at the front of the vehicle to generate a magnetic field with the opposite polarity as the coils at the back of the vehicle. This means that the magnetic fields may extend from the front of the vehicle with a north polarity and from the back of the vehicle with a south polarity or vice versa.

It is also possible for the controller 106 to control the coils 101, 102 at the front of the vehicle to generate a magnetic field with the same polarity as the coils 101, 102 at the back of the vehicle. This means that the magnetic fields may both extend from the front of the vehicle and the back of the vehicle with a north polarity or with a south polarity.

With the coil arrangement 100 an additional braking force may be provided for a vehicle, when deceleration of the vehicle is required.

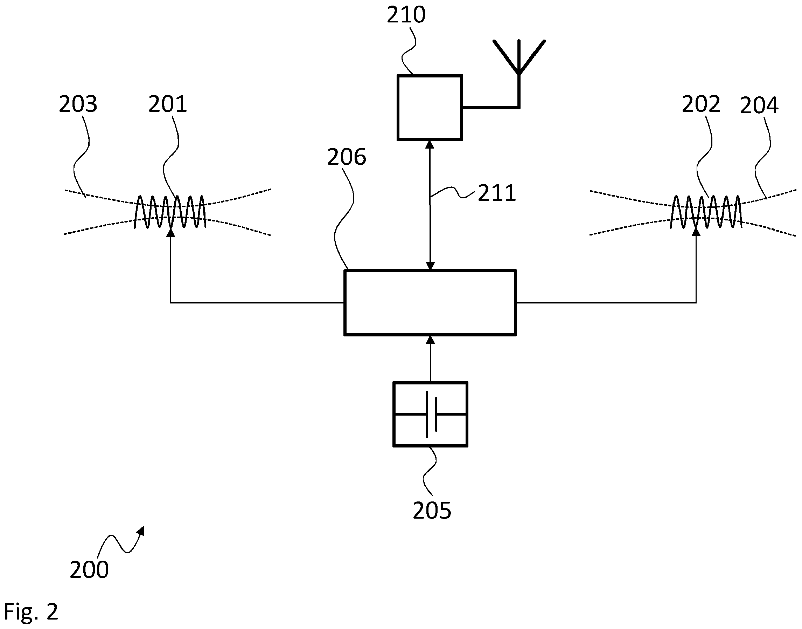

Fig. 2 shows a block diagram of another coil arrangement 200. The coil arrangement 200 is based on the coil arrangement 100. Therefore, the coil arrangement 200 also comprises two exemplary coils 201, 202 that are coupled via controller 206 to an energy storage 205. It is understood, that the above-presented explanations regarding coil arrangement 100 also apply to coil arrangement 200.

Coil arrangement 200 further comprises a wireless communication interface 210 that is coupled to the controller 206. The wireless communication interface 210 serves for communicating controller 206 with other coil arrangements of vehicles that are located in front or behind the vehicle carrying coil arrangement 200.

The controller 206 may use the communication interface 210 to receive an indication 211 of a polarity of a magnetic field generated by an external coil arrangement, e.g. in another vehicle in front of the vehicle carrying the coil arrangement 200. The controller 206 may then control the coils 201, 202 to generate a magnetic field 203, 204 in front of the vehicle with the same polarity, such that both magnetic fields repel each other.

If the controller 206 is provided in the leading vehicle, the controller 106 may receive via the communication interface 210 an indication 211 of a polarity of a magnetic field generated by an external coil arrangement, e.g. in a vehicle behind the vehicle carrying the coil arrangement 200. The controller 206 may then control the coils 101, 102 to generate a magnetic field 103, 104 with the same polarity behind the vehicle.

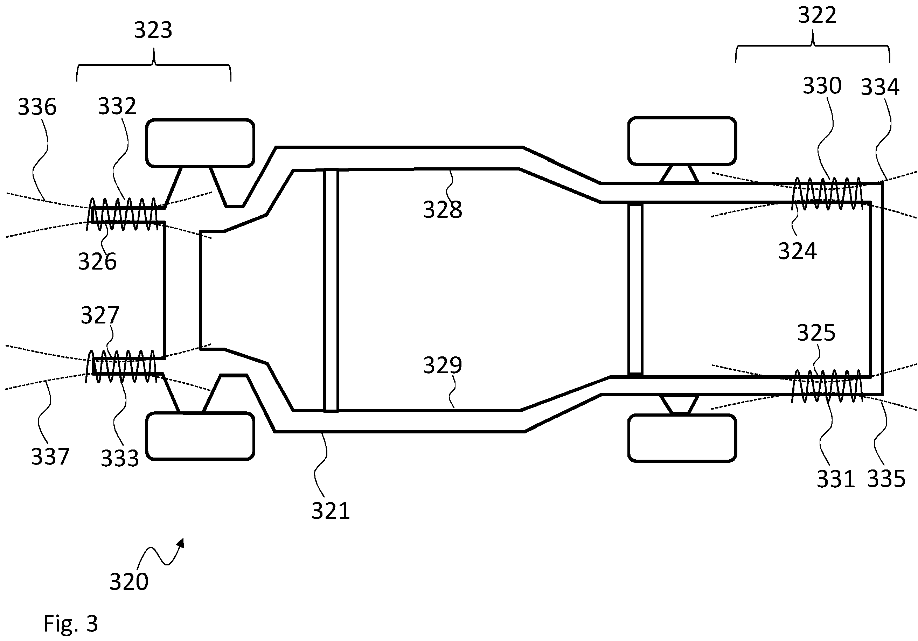

Fig. 3 shows a top view of an embodiment of a vehicle 320. The vehicle 320 comprises a chassis 321 with a front 322 of the vehicle 320 and a back 323 of the vehicle 320. The chassis comprises beams 324, 325, 326, 327, 328, 329 that together with additional crossbeams form a frame for carrying all elements of the vehicle 320.

The beams 324 (front), 328 (center), and 326 (rear) form the left side of the frame, while the beams 325 (front), 329 (center), and 327 (rear) form the right side of the frame. The sides right and left being defined based on a driver's side, when facing to the front of the vehicle 320.

In the exemplary vehicle 320, coils 330, 331, 332, 333 are provided on the beams 324, 325, 326, and 327 of the vehicle 320. With this arrangement by controlling coils 330, 331 it is possible to generate magnetic fields 334, 335 that extend from the front of the vehicle 320. By controlling coils 332, 333 it is possible to generate magnetic fields 336, 337 that extend from the back of the vehicle 320.

For sake of clarity, only the coils 330, 331, 332, 333 are shown in Fig. 3. It is understood, that all other elements pertaining to the coil arrangement according to the present invention may also be provided in the vehicle 320.

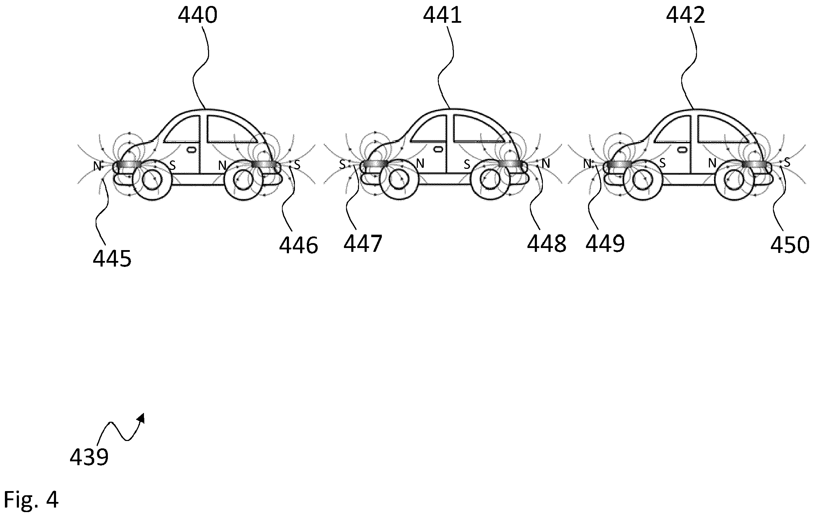

Fig. 4 shows a schematic diagram of a deceleration system 439. The deceleration system 439 comprises three vehicles 440, 441, 442. It is understood, that the number of three vehicles 440, 441, 442 is just exemplarily chosen and that deceleration system 439 may comprise any number of vehicles starting with two vehicles.

Each one of vehicles 440, 441, 442 comprises a coil arrangement according to the present invention. Therefore, the above said regarding Figs. 1 - 3 also applies to the coil arrangements in vehicles 440, 441, 442.

It can be seen that in the deceleration system 439 the single vehicles generate magnetic fields 445, 446, 447, 448, 449, 450 with alternating polarities in each vehicle 440, 441, 442.

The magnetic field 445 at the front of the leading vehicle 440 extends from the vehicle with a north polarity. The magnetic field 446 at the back of the leading vehicle 440 extends from the vehicle with a south polarity.

The magnetic field 447 at the front of the middle vehicle 441 extends from the vehicle with a south polarity. The magnetic field 446 at the back of the middle vehicle 440 extends from the vehicle with a north polarity.

The magnetic field 449 at the front of the trailing vehicle 442 extends from the vehicle with a north polarity. The magnetic field 450 at the back of the trailing vehicle 442 extends from the vehicle with a south polarity.

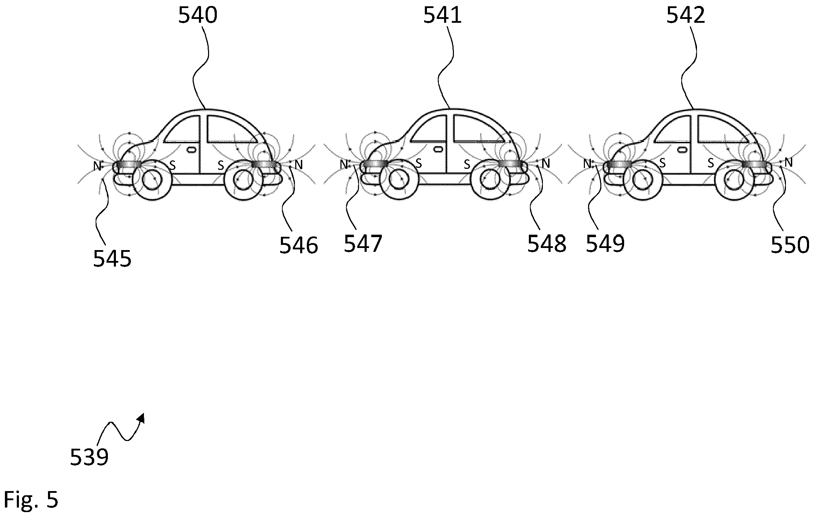

Fig. 5 shows a schematic diagram of another deceleration system 539.

The deceleration system 539 also comprises three vehicles 540, 541, 542. It is understood, that the number of three vehicles 540, 541, 542 is just exemplarily chosen and that deceleration system 539 may comprise any number of vehicles starting with two vehicles.

Each one of vehicles 540, 541, 542 comprises a coil arrangement according to the present invention. Therefore, the above said regarding Figs. 1 - 3 also applies to the coil arrangements in vehicles 540, 541, 542.

It can be seen that in the deceleration system 539 the single vehicles generate magnetic fields 545, 546, 547, 548, 549, 550 with identical polarities extending from each of the vehicles 540, 541, 542.

The magnetic field 545 at the front of the leading vehicle 540 and the magnetic field 546 at the back of the leading vehicle 540 extend from the vehicle with a north polarity.

The magnetic field 547 at the front of the leading vehicle 541 and the magnetic field 548 at the back of the leading vehicle 541 extend from the vehicle with a north polarity.

The magnetic field 549 at the front of the leading vehicle 542 and the magnetic field 550 at the back of the leading vehicle 542 also extend from the vehicle with a north polarity.

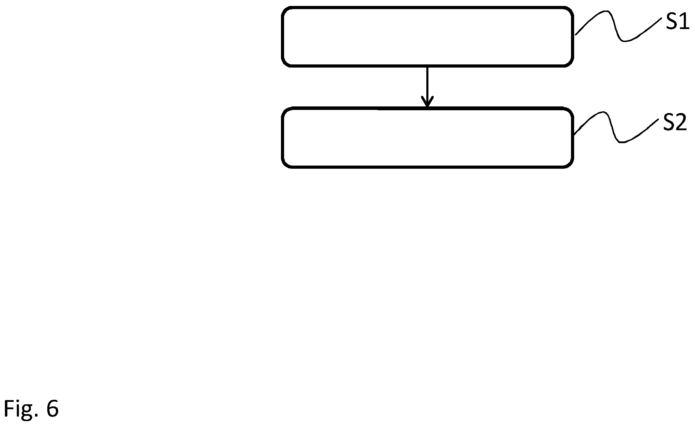

For sake of clarity in the following description of the method-based Fig. 6 the reference signs used above in the description of apparatus-based Figs. 1 - 5 will be maintained.

Fig. 6 shows a flow diagram of an embodiment of a method for decelerating a vehicle 320, 440, 441, 442, 540, 541, 542 with a coil arrangement 100, 200 according to the present invention.

The method comprises storing S1 electrical energy for controllably supplying coils 101, 102, 201, 202, 330, 331, 332, 333 of the coil arrangement 100, 200 with electrical energy, and controlling S2 the energy flow of electrical energy to the coils 101, 102, 201, 202, 330, 331, 332, 333 based on a required strength and/or duration for the magnetic fields 103, 104, 203, 204, 334, 335, 336, 337, 445, 446, 447, 448, 449, 450, 545, 546, 547, 548, 549, 550.

Controlling may also comprise determining based on the speed of the vehicle 320, 440, 441, 442, 540, 541, 542 and/or the distance between the vehicle 320, 440, 441, 442, 540, 541, 542 and another vehicle 320, 440, 441, 442, 540, 541, 542 and/or the momentary deceleration of the vehicle 320, 440, 441, 442, 540, 541, 542 a field strength and a duration for the magnetic fields 103, 104, 203, 204, 334, 335, 336, 337, 445, 446, 447, 448, 449, 450, 545, 546, 547, 548, 549, 550 generated by the coils 101, 102, 201, 202, 330, 331, 332, 333.

Controlling may also comprise sensing via the coils 101, 102, 201, 202, 330, 331, 332, 333 a first polarity of a magnetic field 103, 104, 203, 204, 334, 335, 336, 337, 445, 446, 447, 448, 449, 450, 545, 546, 547, 548, 549, 550 generated by an external coil arrangement 100, 200 in front 322 of the vehicle 320, 440, 441, 442, 540, 541, 542 and controlling the coils 101, 102, 201, 202, 330, 331, 332, 333 to generate a magnetic field 103, 104, 203, 204, 334, 335, 336, 337, 445, 446, 447, 448, 449, 450, 545, 546, 547, 548, 549, 550 in front 322 of the vehicle 320, 440, 441, 442, 540, 541, 542 with a polarity equal to the first polarity.

In addition or as alternative, controlling may comprise sensing via the coils 101, 102, 201, 202, 330, 331, 332, 333 a second polarity of a magnetic field 103, 104, 203, 204, 334, 335, 336, 337, 445, 446, 447, 448, 449, 450, 545, 546, 547, 548, 549, 550 generated by an external coil arrangement 100, 200 behind the vehicle 320, 440, 441, 442, 540, 541, 542 and controlling the coils 101, 102, 201, 202, 330, 331, 332, 333 to generate a magnetic field 103, 104, 203, 204, 334, 335, 336, 337, 445, 446, 447, 448, 449, 450, 545, 546, 547, 548, 549, 550 behind the vehicle 320, 440, 441, 442, 540, 541, 542 with a polarity equal to the second polarity.

Further, the method may comprise receiving via a communication interface 210, for example a wireless communication interface 210, an indication 211 of a first polarity of a magnetic field 103, 104, 203, 204, 334, 335, 336, 337, 445, 446, 447, 448, 449, 450, 545, 546, 547, 548, 549, 550 generated by an external coil arrangement 100, 200 in front 322 of the vehicle 320, 440, 441, 442, 540, 541, 542, wherein controlling in this case may comprise controlling the coils 101, 102, 201, 202, 330, 331, 332, 333 to generate a magnetic field 103, 104, 203, 204, 334, 335, 336, 337, 445, 446, 447, 448, 449, 450, 545, 546, 547, 548, 549, 550 in front 322 of the vehicle 320, 440, 441, 442, 540, 541, 542 with a polarity equal to the first polarity.

Further, the method may also comprise receiving via the communication interface 210 an indication 211 of a second polarity of a magnetic field 103, 104, 203, 204, 334, 335, 336, 337, 445, 446, 447, 448, 449, 450, 545, 546, 547, 548, 549, 550 generated by an external coil arrangement 100, 200 behind the vehicle 320, 440, 441, 442, 540, 541, 542. In this case, controlling may comprise controlling the coils 101, 102, 201, 202, 330, 331, 332, 333 to generate a magnetic field 103, 104, 203, 204, 334, 335, 336, 337, 445, 446, 447, 448, 449, 450, 545, 546, 547, 548, 549, 550 behind the vehicle 320, 440, 441, 442, 540, 541, 542 with a polarity equal to the second polarity.

It is understood, that at least one of the coils 101, 102, 201, 202, 330, 331, 332, 333 may be arranged at the front 322 of the vehicle 320, 440, 441, 442, 540, 541, 542. For example, one coil 101, 102, 201, 202, 330, 331, 332, 333 may be arranged at each one of two sides of the vehicle 320, 440, 441, 442, 540, 541, 542 at the front 322 of the vehicle 320, 440, 441, 442, 540, 541, 542.

In addition, at least one of the coils 101, 102, 201, 202, 330, 331, 332, 333 may be arranged at the back 323 of the vehicle 320, 440, 441, 442, 540, 541, 542. For example, a coil 101, 102, 201, 202, 330, 331, 332, 333 may be arranged at each side of two sides of the vehicle 320, 440, 441, 442, 540, 541, 542 at the back 323 of the vehicle 320, 440, 441, 442, 540, 541, 542.

The step of controlling may comprise controlling the at least one coil 101, 102, 201, 202, 330, 331, 332, 333 at the front 322 of the vehicle 320, 440, 441, 442, 540, 541, 542 to generate a magnetic field 103, 104, 203, 204, 334, 335, 336, 337, 445, 446, 447, 448, 449, 450, 545, 546, 547, 548, 549, 550 with a predefined polarity and controlling the at least one coil 101, 102, 201, 202, 330, 331, 332, 333 at the back 323 of the vehicle 320, 440, 441, 442, 540, 541, 542 to generate a magnetic field 103, 104, 203, 204, 334, 335, 336, 337, 445, 446, 447, 448, 449, 450, 545, 546, 547, 548, 549, 550 with a polarity that is opposed to the predefined polarity.

As alternative, the step of controlling may comprise controlling the at least one coil 101, 102, 201, 202, 330, 331, 332, 333 at the front 322 of the vehicle 320, 440, 441, 442, 540, 541, 542 to generate a magnetic field 103, 104, 203, 204, 334, 335, 336, 337, 445, 446, 447, 448, 449, 450, 545, 546, 547, 548, 549, 550 with a predefined polarity and controlling the at least one coil 101, 102, 201, 202, 330, 331, 332, 333 at the back 323 of the vehicle 320, 440, 441, 442, 540, 541, 542 to generate a magnetic field 103, 104, 203, 204, 334, 335, 336, 337, 445, 446, 447, 448, 449, 450, 545, 546, 547, 548, 549, 550 with the same polarity.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

The present invention provides a coil arrangement 100, 200 for a vehicle 320, 440, 441, 442, 540, 541, 542, the coil arrangement 100, 200 comprising a number of coils 101, 102, 201, 202, 330, 331, 332, 333, each coil 101, 102, 201, 202, 330, 331, 332, 333 being couplable to the vehicle 320, 440, 441, 442, 540, 541, 542 and being configured to controllably generate a magnetic field 103, 104, 203, 204, 334, 335, 336, 337, 445, 446, 447, 448, 449, 450, 545, 546, 547, 548, 549, 550, wherein the longitudinal axis of the coils 101, 102, 201, 202, 330, 331, 332, 333 is parallel to the longitudinal axis of the vehicle 320, 440, 441, 442, 540, 541, 542, an energy storage 105, 205 electrically coupled to the coils 101, 102, 201, 202, 330, 331, 332, 333 and configured to store electrical energy and supply the coils 101, 102, 201, 202, 330, 331, 332, 333 with electrical energy, and a controller 106, 206 electrically coupled between the energy storage 105, 205 and the coils 101, 102, 201, 202, 330, 331, 332, 333 and configured to control the energy flow of electrical energy from the energy storage 105, 205 to the coils 101, 102, 201, 202, 330, 331, 332, 333 based on a required strength and/or duration for the magnetic fields 103, 104, 203, 204, 334, 335, 336, 337, 445, 446, 447, 448, 449, 450, 545, 546, 547, 548, 549, 550. Further, the present invention refers to a vehicle 320, 440, 441, 442, 540, 541, 542, a deceleration system 439, 539 and a method.

### List of reference signs

- 100, 200: coil arrangement
- 101, 102, 201, 202: coil
- 103, 104, 203, 204: magnetic field
- 105, 205: energy storage
- 106, 206: controller
- 210: communication interface
- 211: indication
- 320: vehicle
- 321: chassis
- 322: front of the vehicle
- 323: back of the vehicle
- 324, 325, 326, 327, 328, 329: beam
- 330, 331, 332, 333: coil
- 334, 335, 336, 337: magnetic field
- 439, 539: deceleration system
- 440, 441, 442, 540, 541, 542: vehicle
- 445, 446, 447, 448, 449, 450: magnetic field
- 545, 546, 547, 548, 549, 550: magnetic field
- S1, S2: method steps

## Claims

1. A coil arrangement (100, 200) for a vehicle (320, 440, 441, 442, 540, 541, 542), the coil arrangement (100, 200) comprising:
a number of coils (101, 102, 201, 202, 330, 331, 332, 333), each coil (101, 102, 201, 202, 330, 331, 332, 333) being couplable to the vehicle (320, 440, 441, 442, 540, 541, 542) and being configured to controllably generate a magnetic field (103, 104, 203, 204, 334, 335, 336, 337, 445, 446, 447, 448, 449, 450, 545, 546, 547, 548, 549, 550), wherein the longitudinal axis of the coils (101, 102, 201, 202, 330, 331, 332, 333) is parallel to the longitudinal axis of the vehicle (320, 440, 441, 442, 540, 541, 542),
an energy storage (105, 205) electrically coupled to the coils (101, 102, 201, 202, 330, 331, 332, 333) and configured to store electrical energy and supply the coils (101, 102, 201, 202, 330, 331, 332, 333) with electrical energy, and
a controller (106, 206) electrically coupled between the energy storage (105, 205) and the coils (101, 102, 201, 202, 330, 331, 332, 333) and configured to control the energy flow of electrical energy from the energy storage (105, 205) to the coils (101, 102, 201, 202, 330, 331, 332, 333) based on a required strength and duration for the magnetic fields (103, 104, 203, 204, 334, 335, 336, 337, 445, 446, 447, 448, 449, 450, 545, 546, 547, 548, 549, 550).

2. The coil arrangement (100, 200) according to claim 1, wherein the controller (106, 206) is configured to sense via the coils (101, 102, 201, 202, 330, 331, 332, 333) a first polarity of a magnetic field (103, 104, 203, 204, 334, 335, 336, 337, 445, 446, 447, 448, 449, 450, 545, 546, 547, 548, 549, 550) generated by an external coil arrangement (100, 200) in front (322) of the vehicle (320, 440, 441, 442, 540, 541, 542) and to control the coils (101, 102, 201, 202, 330, 331, 332, 333) to generate a magnetic field (103, 104, 203, 204, 334, 335, 336, 337, 445, 446, 447, 448, 449, 450, 545, 546, 547, 548, 549, 550) in front (322) of the vehicle (320, 440, 441, 442, 540, 541, 542) with a polarity equal to the first polarity, and/or
wherein the controller (106, 206) is configured to sense via the coils (101, 102, 201, 202, 330, 331, 332, 333) a second polarity of a magnetic field (103, 104, 203, 204, 334, 335, 336, 337, 445, 446, 447, 448, 449, 450, 545, 546, 547, 548, 549, 550) generated by an external coil arrangement (100, 200) behind the vehicle (320, 440, 441, 442, 540, 541, 542) and to control the coils (101, 102, 201, 202, 330, 331, 332, 333) to generate a magnetic field (103, 104, 203, 204, 334, 335, 336, 337, 445, 446, 447, 448, 449, 450, 545, 546, 547, 548, 549, 550) behind the vehicle (320, 440, 441, 442, 540, 541, 542) with a polarity equal to the second polarity.

3. The coil arrangement (100, 200) according to claim 1, comprising a communication interface (210), especially a wireless communication interface (210), coupled to the controller (106, 206),
wherein the controller (106, 206) is configured to receive via the communication interface (210) an indication (211) of a first polarity of a magnetic field (103, 104, 203, 204, 334, 335, 336, 337, 445, 446, 447, 448, 449, 450, 545, 546, 547, 548, 549, 550) generated by an external coil arrangement (100, 200) in front (322) of the vehicle (320, 440, 441, 442, 540, 541, 542) and to control the coils (101, 102, 201, 202, 330, 331, 332, 333) to generate a magnetic field (103, 104, 203, 204, 334, 335, 336, 337, 445, 446, 447, 448, 449, 450, 545, 546, 547, 548, 549, 550) in front (322) of the vehicle (320, 440, 441, 442, 540, 541, 542) with a polarity equal to the first polarity, and/or
wherein the controller (106, 206) is configured to receive via the communication interface (210) an indication (211) of a second polarity of a magnetic field (103, 104, 203, 204, 334, 335, 336, 337, 445, 446, 447, 448, 449, 450, 545, 546, 547, 548, 549, 550) generated by an external coil arrangement (100, 200) behind the vehicle (320, 440, 441, 442, 540, 541, 542) and to control the coils (101, 102, 201, 202, 330, 331, 332, 333) to generate a magnetic field (103, 104, 203, 204, 334, 335, 336, 337, 445, 446, 447, 448, 449, 450, 545, 546, 547, 548, 549, 550) behind the vehicle (320, 440, 441, 442, 540, 541, 542) with a polarity equal to the second polarity.

4. The coil arrangement (100, 200) according to any one of the preceding claims, wherein at least one of the coils (101, 102, 201, 202, 330, 331, 332, 333) is arrangeable at the front (322) of the vehicle (320, 440, 441, 442, 540, 541, 542), especially wherein a coil (101, 102, 201, 202, 330, 331, 332, 333) is arrangeable at each one of two sides of the vehicle (320, 440, 441, 442, 540, 541, 542) at the front (322) of the vehicle (320, 440, 441, 442, 540, 541, 542), and/or
wherein at least one of the coils (101, 102, 201, 202, 330, 331, 332, 333) is arrangeable at the back (323) of the vehicle (320, 440, 441, 442, 540, 541, 542), especially wherein a coil (101, 102, 201, 202, 330, 331, 332, 333) is arrangeable at each side of two sides of the vehicle (320, 440, 441, 442, 540, 541, 542) at the back (323) of the vehicle (320, 440, 441, 442, 540, 541, 542).

5. The coil arrangement (100, 200) according to claim 4, wherein the controller (106, 206) is configured to control the at least one coil (101, 102, 201, 202, 330, 331, 332, 333) at the front (322) of the vehicle (320, 440, 441, 442, 540, 541, 542) to generate a magnetic field (103, 104, 203, 204, 334, 335, 336, 337, 445, 446, 447, 448, 449, 450, 545, 546, 547, 548, 549, 550) with a predefined polarity and to control the at least one coil (101, 102, 201, 202, 330, 331, 332, 333) at the back (323) of the vehicle (320, 440, 441, 442, 540, 541, 542) to generate a magnetic field (103, 104, 203, 204, 334, 335, 336, 337, 445, 446, 447, 448, 449, 450, 545, 546, 547, 548, 549, 550) with a polarity that is opposed to the predefined polarity, or
wherein the controller (106, 206) is configured to control the at least one coil (101, 102, 201, 202, 330, 331, 332, 333) at the front (322) of the vehicle (320, 440, 441, 442, 540, 541, 542) to generate a magnetic field (103, 104, 203, 204, 334, 335, 336, 337, 445, 446, 447, 448, 449, 450, 545, 546, 547, 548, 549, 550) with a predefined polarity and to control the at least one coil (101, 102, 201, 202, 330, 331, 332, 333) at the back (323) of the vehicle (320, 440, 441, 442, 540, 541, 542) to generate a magnetic field (103, 104, 203, 204, 334, 335, 336, 337, 445, 446, 447, 448, 449, 450, 545, 546, 547, 548, 549, 550) with the same polarity.

6. The coil arrangement (100, 200) according to any one of the preceding claims, wherein the controller (106, 206) is configured to determine based on the speed of the vehicle (320, 440, 441, 442, 540, 541, 542) and/or the distance between the vehicle (320, 440, 441, 442, 540, 541, 542) and another vehicle (320, 440, 441, 442, 540, 541, 542) and/or the momentary deceleration of the vehicle (320, 440, 441, 442, 540, 541, 542) a field strength and a duration for the magnetic fields (103, 104, 203, 204, 334, 335, 336, 337, 445, 446, 447, 448, 449, 450, 545, 546, 547, 548, 549, 550) generated by the coils (101, 102, 201, 202, 330, 331, 332, 333).

7. Vehicle (320, 440, 441, 442, 540, 541, 542) comprising a coil arrangement (100, 200) according to any one of the preceding claims, wherein the coils (101, 102, 201, 202, 330, 331, 332, 333) of the coil arrangement (100, 200) are arranged wound around beams (324, 325, 326, 327, 328, 329) of the chassis (321) of the vehicle (320, 440, 441, 442, 540, 541, 542).

8. Deceleration system for vehicles (320, 440, 441, 442, 540, 541, 542), the deceleration system (439, 539) comprising:
a first coil arrangement (100, 200) according to any one of the preceding claims 1 to 6 and coupled to a first vehicle (320, 440, 441, 442, 540, 541, 542),
a second coil arrangement (100, 200) according to any one of the preceding claims 1 to 6 and coupled to a second vehicle (320, 440, 441, 442, 540, 541, 542),
wherein the first coil arrangement (100, 200) is configured to generate a first magnetic field (103, 104, 203, 204, 334, 335, 336, 337, 445, 446, 447, 448, 449, 450, 545, 546, 547, 548, 549, 550) of a predetermined polarity between the first vehicle (320, 440, 441, 442, 540, 541, 542) and the second vehicle (320, 440, 441, 442, 540, 541, 542), and
wherein the second coil arrangement (100, 200) is configured to generate a second magnetic field (103, 104, 203, 204, 334, 335, 336, 337, 445, 446, 447, 448, 449, 450, 545, 546, 547, 548, 549, 550) with the predetermined polarity between the first vehicle (320, 440, 441, 442, 540, 541, 542) and the second vehicle (320, 440, 441, 442, 540, 541, 542).

9. Method for decelerating a vehicle (320, 440, 441, 442, 540, 541, 542) with a coil arrangement (100, 200) according to any one of claims 1 - 6, the method comprising:
storing (S1) electrical energy for controllably supplying coils (101, 102, 201, 202, 330, 331, 332, 333) of the coil arrangement (100, 200) with electrical energy, and
controlling (S2) the energy flow of electrical energy to the coils (101, 102, 201, 202, 330, 331, 332, 333) based on a required strength and/or duration for the magnetic fields (103, 104, 203, 204, 334, 335, 336, 337, 445, 446, 447, 448, 449, 450, 545, 546, 547, 548, 549, 550).

10. The method according to claim 9, wherein controlling comprises sensing via the coils (101, 102, 201, 202, 330, 331, 332, 333) a first polarity of a magnetic field (103, 104, 203, 204, 334, 335, 336, 337, 445, 446, 447, 448, 449, 450, 545, 546, 547, 548, 549, 550) generated by an external coil arrangement (100, 200) in front (322) of the vehicle (320, 440, 441, 442, 540, 541, 542) and controlling the coils (101, 102, 201, 202, 330, 331, 332, 333) to generate a magnetic field (103, 104, 203, 204, 334, 335, 336, 337, 445, 446, 447, 448, 449, 450, 545, 546, 547, 548, 549, 550) in front (322) of the vehicle (320, 440, 441, 442, 540, 541, 542) with a polarity equal to the first polarity, and/or
wherein controlling comprises sensing via the coils (101, 102, 201, 202, 330, 331, 332, 333) a second polarity of a magnetic field (103, 104, 203, 204, 334, 335, 336, 337, 445, 446, 447, 448, 449, 450, 545, 546, 547, 548, 549, 550) generated by an external coil arrangement (100, 200) behind the vehicle (320, 440, 441, 442, 540, 541, 542) and controlling the coils (101, 102, 201, 202, 330, 331, 332, 333) to generate a magnetic field (103, 104, 203, 204, 334, 335, 336, 337, 445, 446, 447, 448, 449, 450, 545, 546, 547, 548, 549, 550) behind the vehicle (320, 440, 441, 442, 540, 541, 542) with a polarity equal to the second polarity.

11. The method according to claim 9, comprising receiving via a communication interface (210), especially a wireless communication interface (210), an indication (211) of a first polarity of a magnetic field (103, 104, 203, 204, 334, 335, 336, 337, 445, 446, 447, 448, 449, 450, 545, 546, 547, 548, 549, 550) generated by an external coil arrangement (100, 200) in front (322) of the vehicle (320, 440, 441, 442, 540, 541, 542), wherein controlling comprises controlling the coils (101, 102, 201, 202, 330, 331, 332, 333) to generate a magnetic field (103, 104, 203, 204, 334, 335, 336, 337, 445, 446, 447, 448, 449, 450, 545, 546, 547, 548, 549, 550) in front (322) of the vehicle (320, 440, 441, 442, 540, 541, 542) with a polarity equal to the first polarity, and/or
comprising receiving via the communication interface (210) an indication (211) of a second polarity of a magnetic field (103, 104, 203, 204, 334, 335, 336, 337, 445, 446, 447, 448, 449, 450, 545, 546, 547, 548, 549, 550) generated by an external coil arrangement (100, 200) behind the vehicle (320, 440, 441, 442, 540, 541, 542), wherein controlling comprises controlling the coils (101, 102, 201, 202, 330, 331, 332, 333) to generate a magnetic field (103, 104, 203, 204, 334, 335, 336, 337, 445, 446, 447, 448, 449, 450, 545, 546, 547, 548, 549, 550) behind the vehicle (320, 440, 441, 442, 540, 541, 542) with a polarity equal to the second polarity.

12. The method according to any one of the preceding claims 9 to 11, wherein at least one of the coils (101, 102, 201, 202, 330, 331, 332, 333) is arranged at the front (322) of the vehicle (320, 440, 441, 442, 540, 541, 542), especially wherein a coil (101, 102, 201, 202, 330, 331, 332, 333) is arranged at each one of two sides of the vehicle (320, 440, 441, 442, 540, 541, 542) at the front (322) of the vehicle (320, 440, 441, 442, 540, 541, 542), and/or
wherein at least one of the coils (101, 102, 201, 202, 330, 331, 332, 333) is arranged at the back (323) of the vehicle (320, 440, 441, 442, 540, 541, 542), especially wherein a coil (101, 102, 201, 202, 330, 331, 332, 333) is arranged at each side of two sides of the vehicle (320, 440, 441, 442, 540, 541, 542) at the back (323) of the vehicle (320, 440, 441, 442, 540, 541, 542).

13. The method according to claim 12, wherein controlling comprises controlling the at least one coil (101, 102, 201, 202, 330, 331, 332, 333) at the front (322) of the vehicle (320, 440, 441, 442, 540, 541, 542) to generate a magnetic field (103, 104, 203, 204, 334, 335, 336, 337, 445, 446, 447, 448, 449, 450, 545, 546, 547, 548, 549, 550) with a predefined polarity and controlling the at least one coil (101, 102, 201, 202, 330, 331, 332, 333) at the back (323) of the vehicle (320, 440, 441, 442, 540, 541, 542) to generate a magnetic field (103, 104, 203, 204, 334, 335, 336, 337, 445, 446, 447, 448, 449, 450, 545, 546, 547, 548, 549, 550) with a polarity that is opposed to the predefined polarity, or
wherein controlling comprises controlling the at least one coil (101, 102, 201, 202, 330, 331, 332, 333) at the front (322) of the vehicle (320, 440, 441, 442, 540, 541, 542) to generate a magnetic field (103, 104, 203, 204, 334, 335, 336, 337, 445, 446, 447, 448, 449, 450, 545, 546, 547, 548, 549, 550) with a predefined polarity and controlling the at least one coil (101, 102, 201, 202, 330, 331, 332, 333) at the back (323) of the vehicle (320, 440, 441, 442, 540, 541, 542) to generate a magnetic field (103, 104, 203, 204, 334, 335, 336, 337, 445, 446, 447, 448, 449, 450, 545, 546, 547, 548, 549, 550) with the same polarity.

14. The method according to any one of the preceding claims 9 to 13, wherein controlling comprises determining based on the speed of the vehicle (320, 440, 441, 442, 540, 541, 542) and/or the distance between the vehicle (320, 440, 441, 442, 540, 541, 542) and another vehicle (320, 440, 441, 442, 540, 541, 542) and/or the momentary deceleration of the vehicle (320, 440, 441, 442, 540, 541, 542) a field strength and a duration for the magnetic fields (103, 104, 203, 204, 334, 335, 336, 337, 445, 446, 447, 448, 449, 450, 545, 546, 547, 548, 549, 550) generated by the coils (101, 102, 201, 202, 330, 331, 332, 333).
